# FASCICULE DE BREVET EUROPEEN

(11) **EP 2 983 208 B1**
(45) Date de publication et mention de la délivrance du brevet: **21.06.2017**
(21) Numéro de dépôt: 14180159.7
(22) Date de dépôt: 07.08.2014
(51) Int. Cl.: H01L 27/32, G04C 10/02, G02F 1/1333, G02F 1/1335

(54) **Ensemble d'affichage hybride comprenant une cellule solaire**
Hybridanzeige mit einer Solarzelle
Hybrid display having a solar cell

(43) Date de publication de la demande: 10.02.2016
(73) Titulaire: The Swatch Group Research and Development Ltd., 2074 Marin (CH)
(72) Inventeur: Sagardoyburu, Michel, 2000 Neuchâtel (CH)
(74) Mandataire: Supper, Marc

(56) Documents cités:
- US-A1- 2011 128 264

## Description

### Domaine de l'invention

La présente invention concerne un ensemble d'affichage hybride comprenant une cellule solaire. Plus précisément, la présente invention concerne un tel ensemble d'affichage comprenant deux dispositifs d'affichage superposés sous lesquels est disposée une cellule solaire.

### Arrière-plan technologique de l'invention

La lisibilité des informations affichées par les dispositifs d'affichage digitaux tels que les cellules d'affichage à cristaux liquides est notamment déterminée par la surface qu'offre le dispositif d'affichage digital pour afficher des informations. Pour une surface d'affichage donnée, il faut donc trouver un compromis entre le nombre et la taille des informations que l'on souhaite afficher. Plus la taille des informations affichées sera grande, meilleure sera la lisibilité des informations. Néanmoins, le nombre d'informations qu'il sera possible d'afficher sera nécessairement limité. Inversement, si l'on réduit la taille des informations affichées, on peut augmenter leur nombre, mais cela se fera au détriment de la lisibilité.

Pour pallier cet inconvénient, il a déjà été proposé de disposer un second dispositif d'affichage sous un premier dispositif d'affichage. On peut ainsi afficher les informations pour partie avec le premier dispositif d'affichage, et pour partie avec le second dispositif d'affichage. En commutant entre le premier et le second dispositif d'affichage, on peut faire apparaître au choix les informations affichées par le premier ou le second dispositif d'affichage, ce qui permet d'afficher un nombre plus important d'informations et selon une plus grande taille.

L'inconvénient d'un tel ensemble d'affichage comprenant deux dispositifs d'affichage superposés est sa consommation en énergie électrique qui est assez importante. Or, de tels ensembles d'affichage sont habituellement destinés à être embarqués dans des objets portables de petites dimensions tels que des montres-bracelets dont les réserves en énergie sont limitées.

D'autre part, la lisibilité des informations affichées par les dispositifs d'affichage tels que les cellules d'affichage à cristaux liquides ou bien les dispositifs d'affichage à diodes organiques électroluminescentes est très dépendante des conditions de luminosité ambiante. Avec certains dispositifs d'affichage, les informations affichées peuvent être lues dans de bonnes conditions dans un environnement éclairé, mais par contre sont difficiles à lire dans un environnement sombre. Inversement, d'autres catégories de dispositifs d'affichage fournissent un affichage de bonne qualité dans la pénombre ou l'obscurité, mais sont difficilement lisibles en plein jour.

A titre d'exemple, considérons les cellules d'affichage à cristal liquide de type transflectif, c'est-à-dire des cellules d'affichage à cristal liquide capables d'afficher des informations qui vont être visibles de jour grâce à un phénomène de réflexion, et qui vont être également visibles dans le noir par transmission en utilisant un dispositif de rétroéclairage. De telles cellules d'affichage à cristal liquide de type transflectif sont optimisées pour pouvoir réfléchir au mieux la lumière du soleil et ainsi garantir une bonne lisibilité des informations affichées dans des conditions de forte luminosité ambiante. Cependant, afin que de telles cellules d'affichage à cristal liquide de type transflectif puissent réfléchir au mieux la lumière du soleil, leur efficacité en transmission est fortement limitée. Ainsi, lorsque le dispositif de rétroéclairage est activé afin de permettre de lire les informations affichées dans la pénombre, une majeure partie de la lumière émise par le dispositif de rétroéclairage se perd dans des phénomènes d'absorption. Le rendement énergétique est donc mauvais. En outre, les qualités optiques des informations affichées par la cellule à cristal liquide sont fortement dépendantes de l'angle de vue.

En ce qui concerne les dispositifs d'affichage de type émissif tels que les dispositifs d'affichage à diodes organiques électroluminescentes, ils présentent des qualités optiques qui sont supérieures à celles des cellules d'affichage à cristal liquide, ces qualités optiques ne dépendant notamment pas de l'angle de vue. Néanmoins, ces dispositifs d'affichage de type émissif de haute qualité ne permettent pas un fonctionnement en mode réflectif. Les informations qu'ils affichent sont donc très lisibles dans la pénombre ou l'obscurité, mais deviennent difficilement lisibles dès qu'elles sont observées en extérieur. Pour remédier à ce problème, il est possible d'augmenter la quantité de courant fournie aux dispositifs d'affichage émissifs afin de garantir un minimum de lisibilité. Toutefois, même en conditions d'utilisations normales, ces dispositifs d'affichage émissifs consomment davantage qu'une cellule à cristal liquide de type réflectif. Leur consommation électrique est telle qu'il est difficilement envisageable de les conserver allumés en permanence, en particulier lorsqu'ils sont embarqués dans un objet portable de petites dimensions tels qu'une montre-bracelet dont la seule source d'énergie est une pile dont on souhaite habituellement qu'elle dure au moins un an. Le document US 2011/0128264 est considéré comme l'état de la technique antérieur le plus proche à l'invention. Ce document divulgue les caractéristiques techniques du préambule de la revendication 1 : c'est à dire un ensemble d'affichage transflectif pour un objet portable, cet ensemble d'affichage comprenant un premier dispositif d'affichage qui est fourni par une cellule d'affichage à cristal liquide de type PDLC (dans lequel des domaines de cristal liquide sont dispersés dans une matrice polymère) ou de type cholestérique. Le premier dispositif est au moins partiellement transparent et est situé du côté d'un observateur. Un deuxième dispositif d'affichage émissif, aussi au moins partiellement transparent, est basé sur une cellule électroluminescente comprenant des diodes organiques électroluminescentes et est situé sous le premier dispositif d'affichage. En outre, une cellule solaire est disposée sous le deuxième dispositif d'affichage. Les premier et deuxième dispositifs d'affichage sont capables de commuter entre un état actif dans lequel ils affichent une information et un état passif dans lequel ils n'affichent pas d'information.

### Résumé de l'invention

La présente invention a pour but de remédier aux problèmes susmentionnés ainsi qu'à d'autres encore en procurant un ensemble d'affichage dont les besoins en énergie peuvent être satisfaits même lorsqu'il est embarqué dans un objet portable de petites dimensions tel qu'une montre-bracelet dont les réserves en énergie sont pourtant limitées. La présente invention procure également un ensemble d'affichage dont le fonctionnement est satisfaisant aussi bien dans un environnement fortement éclairé que dans un environnement sombre.

A cet effet, la présente invention concerne un ensemble d'affichage selon la revendication 1. Grâce à ces caractéristiques, la présente invention procure un ensemble d'affichage comprenant deux dispositifs d'affichage superposés, à savoir un premier dispositif d'affichage affichant une première information, et un second dispositif d'affichage affichant une seconde information. Il est donc possible d'afficher des informations pour partie avec le premier dispositif d'affichage, et pour partie avec le second dispositif d'affichage. En commutant entre le premier et le second dispositif d'affichage, on peut faire apparaître au choix les informations affichées par le premier ou le second dispositif d'affichage, ce qui permet d'afficher un nombre plus important d'informations et selon une plus grande taille. En outre, en enseignant de disposer une cellule solaire sous les deux dispositifs d'affichage superposés, la présente invention permet l'intégration d'un tel ensemble dans un objet portable de petites dimensions dont les réserves en énergie électrique sont nécessairement limitées. En effet, on a constaté que la quantité de lumière qui parvenait à la cellule solaire à travers l'ensemble des deux dispositifs d'affichage superposés était suffisante pour fournir, par phénomène de conversion photoélectrique, la quantité d'énergie électrique nécessaire au fonctionnement des deux dispositifs d'affichage superposés. Par conséquent, les réserves d'énergie électrique de l'objet portable sont peu, ou pas sollicitées par le fonctionnement des deux dispositifs d'affichage superposés. En outre, le premier dispositif d'affichage situé du côté de l'observateur est de type réflectif, et le second dispositif d'affichage disposé sous le premier dispositif d'affichage est de type émissif.

Grâce à ces autres caractéristiques, la présente invention procure un ensemble d'affichage pour un objet portable tel qu'une montre-bracelet dont le fonctionnement est optimal quelles que soient les conditions d'éclairement ambiant. En plein jour, les informations seront préférentiellement affichées par le dispositif d'affichage réflectif. En effet, ce dispositif d'affichage réflectif, utilisant un phénomène de réflexion de la lumière du soleil pour afficher les informations, est économe en énergie. Il peut donc rester allumé en permanence et offrir une bonne lisibilité des informations en conditions de forte luminosité ambiante. Inversement, dans la pénombre ou l'obscurité, les informations seront préférentiellement affichées par le dispositif d'affichage émissif. Un tel dispositif d'affichage émissif consomme davantage de courant électrique qu'un dispositif d'affichage réflectif, mais les informations qu'il affiche sont visibles de nuit ou dans l'obscurité avec de très bonnes propriétés optiques qui sont notamment totalement indépendantes de l'angle de vue. En particulier, le premier dispositif d'affichage comprend une cellule d'affichage à cristal liquide réflective, et le second dispositif d'affichage comprend une cellule d'affichage émissive transparente de type électroluminescent qui est basée sur les diodes organiques électroluminescentes.

### Brève description des figures

D'autres caractéristiques et avantages de la présente invention ressortiront plus clairement de la description détaillée qui suit d'un mode de réalisation de l'ensemble d'affichage selon l'invention, cet exemple étant donné à titre purement illustratif et non limitatif seulement en liaison avec le dessin annexé sur lequel :
- la figure 1 est une vue schématique en coupe illustrant un ensemble d'affichage selon l'invention sous lequel est disposée une cellule solaire ;
- la figure 2 est une vue en coupe d'un exemple de réalisation d'un ensemble d'affichage selon l'invention dont le premier dispositif d'affichage comprend une cellule d'affichage à cristal liquide réflective, et dont le second dispositif d'affichage comprend une cellule d'affichage émissive transparente à diodes organiques électroluminescentes, une cellule solaire étant disposée sous cet ensemble d'affichage, et
- les figures 3A à 3D illustrent schématiquement le mode de fonctionnement de l'ensemble d'affichage illustré à la figure 2 selon que la cellule d'affichage à cristal liquide et la cellule d'affichage à diodes organiques électroluminescentes sont actives ou passives.

### Description détaillée d'un mode de réalisation de l'invention

La présente invention procède de l'idée générale inventive qui consiste à disposer une cellule solaire sous un ensemble de deux dispositifs d'affichage superposés capables de commuter entre un état actif dans lequel ils consomment de l'énergie électrique pour afficher une information, et un état passif dans lequel ils ne consomment pas d'énergie électrique et n'affichent aucune information. Grâce à l'utilisation de deux dispositifs d'affichage superposés, on peut afficher des informations pour partie avec le premier dispositif d'affichage, et pour partie avec le second dispositif d'affichage. En commutant entre le premier et le second dispositif d'affichage, on peut faire apparaître au choix les informations affichées par le premier ou le second dispositif d'affichage, ce qui permet d'afficher un nombre plus grand d'informations et selon une plus grande taille. On s'est rendu compte en outre qu'en disposant une cellule solaire sous les deux dispositifs d'affichage superposés, la cellule solaire procurait, par effet de conversion photoélectrique, un courant électrique suffisant pour permettre le fonctionnement des deux dispositifs d'affichage superposés. Il est donc possible d'intégrer un tel ensemble d'affichage dans un objet portable de petites dimensions tel qu'une montre-bracelet dont les capacités de stockage en énergie électrique sont pourtant limitées. Le premier dispositif d'affichage situé du côté de l'observateur est de type réflectif, et le second dispositif d'affichage disposé sous le premier dispositif d'affichage est de type émissif. Le fonctionnement de l'ensemble d'affichage selon l'invention est donc optimal quelles que soient les conditions d'éclairement ambiant. En plein jour, les informations seront préférentiellement affichées par le dispositif d'affichage réflectif qui utilise un phénomène de réflexion de la lumière du soleil pour afficher les informations. Inversement, dans la pénombre ou l'obscurité, les informations seront affichées par le dispositif d'affichage émissif qui est capable d'émettre de la lumière en consommant de l'énergie électrique.

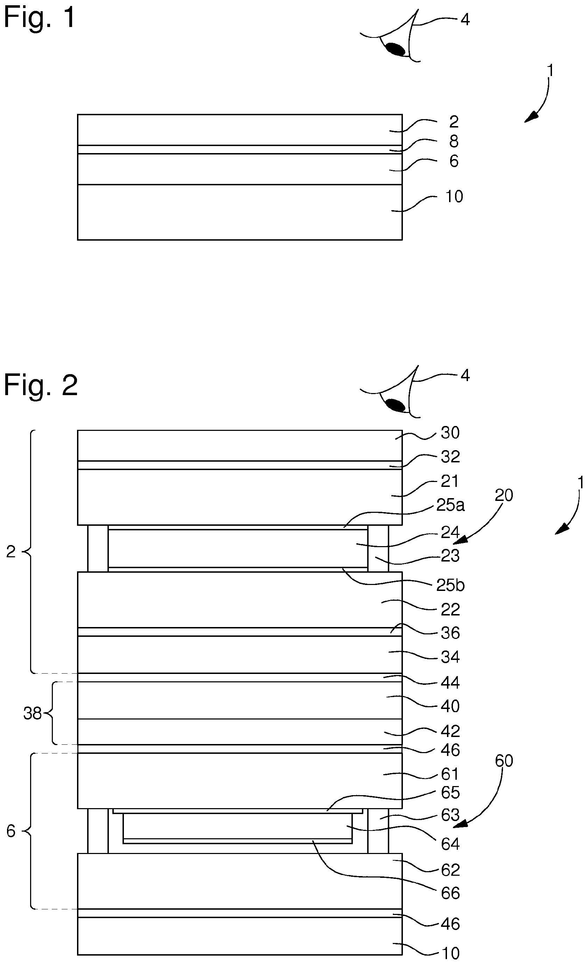

La figure 1 est une vue schématique en coupe d'un ensemble d'affichage selon l'invention. Désigné dans son ensemble par la référence numérique générale 1, cet ensemble d'affichage comprend un premier dispositif d'affichage 2 au moins partiellement transparent disposé du côté d'un observateur 4, et un second dispositif d'affichage 6 lui aussi au moins partiellement transparent disposé sous le premier dispositif d'affichage 2.

Au sens de la présente invention, les premier et second dispositifs d'affichage 2, 6 sont des dispositifs d'affichage capables de commuter entre un état dans lequel ils consomment de l'énergie électrique pour afficher une information, et un état passif dans lequel ils ne consomment pas d'énergie électrique et n'affichent aucune information.

De préférence, le premier dispositif d'affichage 2 est solidarisé sur le second dispositif d'affichage 6 au moyen d'une couche adhésive transparente 8. Cette couche adhésive transparente 8 peut être formée d'un adhésif en film ou d'une couche de colle liquide acrylique ou silicone. Cette couche adhésive 8 a pour objet d'éviter les problèmes de réflexions parasites qui surviendraient si les deux dispositifs d'affichage 2, 6 étaient séparés par une couche d'air et qui dégraderaient la qualité optique de l'ensemble d'affichage 1 selon l'invention.

Enfin, une cellule solaire 10 capable de fournir de l'énergie électrique en exploitant le phénomène de conversion photoélectrique est disposée sous le second dispositif d'affichage 6.

La figure 2 est une vue en coupe détaillée d'un exemple de réalisation de l'ensemble d'affichage 1 selon l'invention. Le premier dispositif d'affichage 2 comprend une cellule d'affichage à cristal liquide réflective 20, et le second dispositif d'affichage 6 comprend une cellule d'affichage émissive transparente 60 à diodes organiques électroluminescentes qui sera désignée dans tout ce qui suit par cellule d'affichage transparente TOLED (Transparent Organic Light Emitting Diode). Enfin, la cellule solaire 10 est disposée sous cet ensemble d'affichage 1.

Plus précisément, la cellule d'affichage à cristal liquide réflective 20 comprend un substrat avant 21 disposé du côté de l'observateur 4 et un substrat arrière 22 qui s'étend parallèlement à et à distance du substrat avant 21. Les substrats avant 21 et arrière 22 sont réunis entre eux par un cadre de scellement 23 qui délimite une enceinte étanche 24 pour le confinement d'un cristal liquide dont les propriétés optiques sont modifiées par application d'une tension appropriée à un point de croisement considéré entre des électrodes transparentes 25a ménagées sur une face inférieure du substrat avant 21 et des contre-électrodes transparentes 25b ménagées sur une face supérieure de substrat arrière 22. Les électrodes 25a et les contre-électrodes 25b sont réalisées en un matériau transparent électriquement conducteur tel que de l'oxyde d'indium-zinc ou de l'oxyde d'indium-étain, ce dernier matériau étant mieux connu sous sa dénomination anglo-saxonne Indium Tin Oxide ou ITO.

Dans le cas de la présente invention, toutes les phases des cristaux liquides telles que nématique en hélice (Twist Nematic ou TN en terminologie anglo-saxonne), super-nématique en hélice (Super Twist Nematic ou STN en terminologie anglo-saxonne) ou bien encore à alignement vertical (Vertically Aligned ou VA en terminologie anglo-saxonne) peuvent être envisagées. De même, tous les types d'adressage tels qu'adressage direct, adressage par matrice active ou adressage multiplexé d'une matrice passive peuvent être envisagés.

Un polariseur absorbant 30 est collé sur une face supérieure du substrat avant 21 de la cellule d'affichage à cristal liquide réflective 20 au moyen d'une couche adhésive 32. Cette couche adhésive 32 peut être formée d'un adhésif en film ou d'une couche de colle liquide. La colle utilisée pour solidariser le polariseur absorbant 30 sur la cellule d'affichage à cristal liquide réflective 20 peut-être transparente ou légèrement diffusante selon que l'on cherche à obtenir une réflexion spéculaire ou bien diffuse. Quant au polariseur absorbant 30, il peut être, par exemple, du type à iodine ou à colorant.

Un polariseur réflectif 34 est collé sur une face inférieure du substrat arrière 22 de la cellule d'affichage à cristal liquide réflective 20 au moyen d'une couche adhésive 36 qui peut être transparente ou légèrement diffusante selon que l'on cherche à obtenir une réflexion spéculaire ou bien diffuse. Quant au polariseur réflectif 34, il peut être du type à grille de fils, mieux connu sous sa dénomination anglo-saxonne Wire Grid Polarizer. Il peut également s'agir d'un polariseur composé d'une succession de couches biréfringentes qui provoquent la réflexion ou la transmission de la polarisation par un effet d'interférences constructives ou destructives, comme les polariseurs du type Dual Brightness Enhancement Film (DBEF) ou du type APF commercialisés par la société américaine 3M®.

Comme on le verra en détail ci-après, la cellule d'affichage à cristal liquide réflective 20 est, à titre préféré mais non obligatoire, collée sur la cellule d'affichage transparente TOLED 60 avec interposition d'un polariseur circulaire 38. Cette cellule d'affichage transparente TOLED 60 comprend un substrat transparent 61 réalisé en verre ou en un matériau plastique et un capot d'encapsulation 62 qui s'étend parallèlement à et à distance du substrat transparent 61. Le substrat transparent 61 et le capot d'encapsulation 62 sont réunis entre eux par un cadre de scellement 63 qui délimite un volume clos à l'abri de l'air et de l'humidité pour le confinement d'un empilement de couches électroluminescentes généralement désigné par la référence numérique 64. Une électrode supérieure transparente 65 réalisée par exemple en oxyde d'étain-indium ou ITO et une électrode inférieure transparente 66 réalisée par exemple au moyen d'un matériau métallique tel que l'aluminium ou l'or ou d'un oxyde métallique tel que l'ITO ou l'oxyde de zinc-indium sont structurées de part et d'autre de l'empilement des couches électroluminescentes 64. Ces électrodes 65, 66, réalisées en un matériau métallique, sont légèrement réfléchissantes. Les cellules d'affichage transparentes à diodes organiques électroluminescentes sont disponibles soit avec un adressage direct dans les cas où il s'agit simplement d'afficher des icônes ou des segments, soit avec un adressage du type à matrice passive dans le cas d'un affichage matriciel à points. Dans le cas d'un affichage à matrice de points, on peut également avoir à faire à un adressage du type à matrice active combiné avec des transistors transparents du type Thin Film Transistor ou TFT destinés à contrôler le courant et qui sont ménagés dans les pixels d'affichage situés du côté du substrat 61 de la cellule d'affichage transparente TOLED 60.

De préférence, un polariseur circulaire 38 est disposé entre la cellule d'affichage à cristal liquide réflective 20 et la cellule d'affichage transparente TOLED 60. Ce polariseur circulaire 38 a pour but d'améliorer les qualités optiques de l'ensemble d'affichage 1 en absorbant les réflexions parasites produites par les électrodes transparentes 65 et 66. Il est toutefois possible de se passer de ce polariseur circulaire 38 si l'on souhaite réaliser des économies ou obtenir un gain de place. Ce polariseur circulaire 38 comprend un polariseur linéaire absorbant 40 et une lame quart d'onde 42. Du côté de la cellule d'affichage à cristal liquide réflective 20, le polariseur circulaire 38 est collé sur le polariseur réflectif 34 au moyen d'une couche adhésive transparente 44, et du côté de la cellule d'affichage transparente TOLED 60, le polariseur circulaire 38 est collé sur le substrat 61 au moyen d'une couche adhésive transparente 46. Pour des raisons qui seront détaillées ci-dessous, l'axe de transmission du polariseur absorbant 40 est orienté parallèlement à l'axe de transmission du polariseur réflectif 34.

Finalement, la cellule solaire 10 est disposée sous l'empilement formé par la cellule d'affichage à cristal liquide réflective 20 et la cellule d'affichage transparente TOLED 60, du côté opposé à l'observateur 4. De préférence, la cellule solaire 10 est solidarisée sur la face inférieure du capot d'encapsulation 62 au moyen d'une couche adhésive transparente 46.

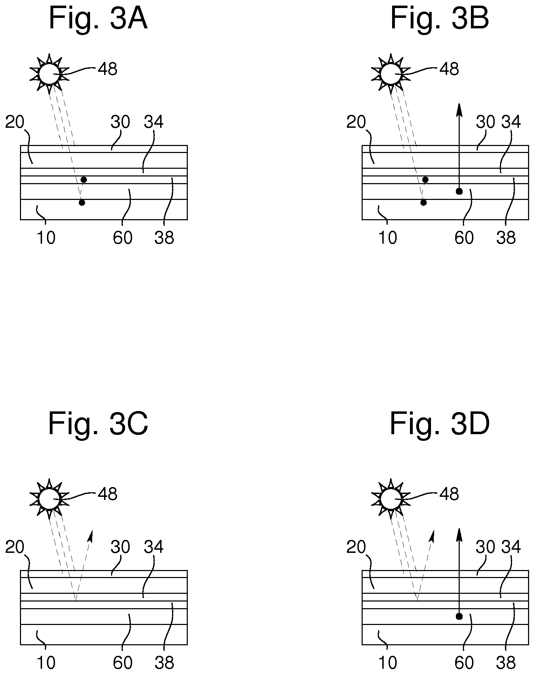

On examine maintenant en liaison avec les figures 3A à 3D les principes de fonctionnement de l'ensemble d'affichage 1 selon l'invention selon que la cellule d'affichage à cristal liquide réflective 20 et la cellule d'affichage transparente TOLED 60 sont en service ou non. On supposera, à titre d'exemple illustratif et non limitatif seulement, que la cellule d'affichage à cristal liquide réflective 20 est une cellule à cristal liquide nématique en hélice ou TN et que les axes de transmission du polariseur absorbant 30 et du polariseur réflectif 34 sont perpendiculaires. A la figure 3A, la cellule d'affichage à cristal liquide réflective 20 et la cellule d'affichage transparente TOLED 60 sont toutes les deux éteintes. La lumière ambiante, désignée par la référence numérique 48, est polarisée linéairement par le polariseur absorbant 30. La lumière ambiante 48 subit ensuite une rotation de 90° lorsqu'elle traverse la cellule d'affichage à cristal liquide réflective 20. Comme l'axe de transmission du polariseur réflectif 34 s'étend selon une direction perpendiculaire à la direction dans laquelle s'étend l'axe de transmission du polariseur absorbant 30, le polariseur réflectif 34 laisse passer sans modification la lumière ambiante 48 qui s'échappe de la cellule d'affichage à cristal liquide réflective 20. La lumière ambiante 48 est ensuite polarisée circulairement par le polariseur circulaire 38 et est transmise sans absorption par le polariseur absorbant 40 dont l'axe de transmission est orienté parallèlement à l'axe de transmission du polariseur réflectif 34. Finalement, la lumière ambiante 48 traverse la cellule d'affichage transparente TOLED 60. Une faible partie de la lumière ambiante 48 se réfléchit sur les électrodes supérieure et inférieure transparentes 65 et 66, de sorte que son sens de rotation de la polarisation circulaire est inversé et qu'elle est absorbée lorsqu'elle traverse à nouveau le polariseur circulaire 38. Quant au reste de la lumière ambiante 48, il traverse la cellule d'affichage transparente TOLED 60 sans modification et est absorbé par la cellule solaire 10 qui présente un aspect foncé ou noir. L'ensemble d'affichage 1 apparaît ainsi noir au regard de l'observateur 4.

A la figure 3B, la cellule d'affichage à cristal liquide réflective 20 est désactivée, tandis que la cellule d'affichage transparente TOLED 60 est activée. La lumière ambiante 48, polarisée linéairement par le polariseur absorbant 30, subit une rotation de 90° lorsqu'elle traverse la cellule d'affichage à cristal liquide réflective 20, puis est transmise sans modification par le polariseur réflectif 34. La lumière ambiante 48 est ensuite polarisée circulairement par le polariseur circulaire 38 qui la transmet sans absorption étant donné que l'axe de transmission du polariseur absorbant 40 est orienté parallèlement à l'axe de transmission du polariseur réflectif 34. Finalement, la lumière ambiante 48 pénètre dans la cellule d'affichage transparente TOLED 60. Une faible fraction de la lumière ambiante 48 est ensuite réfléchie par les électrodes supérieure et inférieure transparentes 65, 66 de la cellule d'affichage transparente TOLED 60. Au moment de la réflexion, le sens de rotation de la polarisation circulaire de la lumière s'inverse de sorte que, lorsque la lumière traverse à nouveau le polariseur circulaire 38, elle est absorbée par ce dernier. Quant au reste de la lumière ambiante 48, il est absorbé par la cellule solaire 10. D'autre part, la moitié de la lumière émise par la cellule d'affichage transparente TOLED 60 est absorbée par le polariseur absorbant 40, tandis que l'autre moitié de la lumière, polarisée linéairement, traverse successivement le polariseur réflectif 34, la cellule d'affichage à cristal liquide réflective 20 et le polariseur absorbant 30 sans être absorbée. Les informations affichées apparaissent ainsi en clair sur un fond sombre.

A la figure 3C, la cellule d'affichage à cristal liquide réflective 20 est activée, tandis que la cellule d'affichage transparente TOLED 60 est éteinte. Dans les zones de la cellule d'affichage à cristal liquide réflective 20 qui ne sont pas commutées, la lumière ambiante 48, polarisée linéairement par le polariseur absorbant 30, subit une rotation de 90° lorsqu'elle traverse la cellule d'affichage à cristal liquide réflective 20, puis est transmise sans modification par le polariseur réflectif 34. La lumière ambiante 48 est ensuite polarisée circulairement par le polariseur circulaire 38 qui la transmet sans absorption étant donné que l'axe de transmission du polariseur absorbant 40 est orienté parallèlement à l'axe de transmission du polariseur réflectif 34. Finalement, la lumière ambiante 48 pénètre dans la cellule d'affichage transparente TOLED 60. Une faible fraction de la lumière ambiante 48 est réfléchie par les électrodes supérieure et inférieure transparentes 65 et 66. A ce moment-là, le sens de rotation de la polarisation circulaire s'inverse, de sorte que lorsque la lumière traverse à nouveau le polariseur circulaire 38, elle est absorbée par ce dernier. Le reste de la lumière ambiante 48 est absorbé par la cellule solaire 10. D'autre part, dans les zones de la cellule d'affichage à cristal liquide réflective 20 qui sont commutées, la lumière ambiante 48 est transmise sans modification, de sorte que la direction de polarisation de la lumière ambiante 48 se retrouve perpendiculaire à l'axe de transmission du polariseur réflectif 34 et donc parallèle à l'axe de réflexion de ce même polariseur 34. Par conséquent, la lumière ambiante 48 est réfléchie par le polariseur réflectif 34 en direction de la cellule d'affichage à cristal liquide réflective 20. Dans les zones de la cellule d'affichage à cristal liquide réflective 20 qui sont commutées, les molécules de cristal liquide ne modifient pas la direction de polarisation de la lumière ambiante 48 lorsque celle-ci traverse une nouvelle fois la cellule d'affichage à cristal liquide réflective 20, de sorte que la lumière ambiante 48 n'est pas absorbée par le polariseur absorbant 30 lors de son trajet retour, ce qui permet de réaliser le mode d'affichage réflectif de l'ensemble d'affichage 1.

A la figure 3D, la cellule d'affichage à cristal liquide réflective 20 et la cellule d'affichage transparente TOLED 60 sont toutes deux activées. Dans les zones de la cellule d'affichage à cristal liquide réflective 20 qui sont commutées, la fraction de la lumière ambiante 48 réfléchie par le polariseur réflectif 34 n'est pas absorbée par le polariseur absorbant 30 et est perceptible par l'observateur 4, ce qui permet à la cellule d'affichage à cristal liquide réflective 20 d'afficher les informations en mode réflectif. Quant au restant de la lumière ambiante, il est absorbé par la cellule solaire 10. D'autre part, la moitié de la lumière émise par la cellule d'affichage transparente TOLED 60 est absorbée par le polariseur circulaire 38, tandis que l'autre moitié de la lumière émise par la cellule d'affichage transparente TOLED 60 traverse le polariseur circulaire 38, la cellule d'affichage à cristal liquide 20 et le polariseur absorbant 30 sans être absorbée, de sorte qu'elle est perceptible par l'observateur 4.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées à la présente demande de brevet. On comprendra en particulier que dire que la lumière ambiante traverse sans modification la cellule d'affichage à cristal liquide réflective ou la cellule d'affichage transparente TOLED sans modification est quelque peu un abus de langage. En effet, lorsque la lumière ambiante traverse ces cellules d'affichage, il se produit toujours des phénomènes minimes de réflexion parasite de la lumière. Ces réflexions parasites sont néanmoins tout à fait négligeables dans le cadre de la présente invention. On aura également compris de ce qui a été dit ci-dessus que parler d'électrodes « transparentes » est également quelque peu un abus de langage. En effet, bien que réalisées en un matériau transparent électriquement conducteur, ces électrodes sont toujours très légèrement réfléchissantes. La cellule d'affichage à cristal liquide réflective est choisie dans le groupe formé par les cellules d'affichage à cristal liquide de type nématique en hélice, les cellules d'affichage à cristal liquide de type super nématique en hélice et les cellules d'affichage à cristal liquide de type à alignement vertical. A titre de variante, le second dispositif d'affichage comprend une cellule d'affichage électroluminescente agencée pour commuter entre un état actif dans lequel elle émet de la lumière pour afficher une information et un état passif dans lequel elle n'émet aucune lumière.

### Nomenclature

Ensemble d'affichage 1
Premier dispositif d'affichage 2
Observateur 4
Second dispositif d'affichage 6
Couche adhésive 8
Cellule solaire 10
Cellule d'affichage à cristal liquide réflective 20
Substrat avant 21
Substrat arrière 22
Cadre de scellement 23
Enceinte étanche 24
Electrodes transparentes 25a
Contre-électrodes transparentes 25b
Polariseur absorbant 30
Couche adhésive 32
Polariseur réflectif 34
Couche adhésive 36
Polariseur circulaire 38
Polariseur linéaire absorbant 40
Lame quart d'onde 42
Couche adhésive transparente 44
Couche adhésive transparente 46
Lumière ambiante 48
Cellule d'affichage transparente TOLED 60
Substrat 61
Capot d'encapsulation 62
Cadre de scellement 63
Empilement de couches électroluminescentes 64
Electrode supérieure transparente 65
Electrode inférieure transparente 66

## Revendications

1. Ensemble d'affichage d'au moins une information pour un objet portable, cet ensemble d'affichage (1) comprenant un premier dispositif d'affichage (2) au moins partiellement transparent situé du côté d'un observateur (4) et qui est agencé pour afficher au moins une première information, ce premier dispositif d'affichage (2) comprenant une cellule d'affichage à cristal liquide (20) agencée pour commuter entre un état actif dans lequel elle est réflective et affiche une information, et un état passif dans lequel elle est transparente et n'affiche pas d'information, l'ensemble d'affichage (1) comprenant également un second dispositif d'affichage (6) au moins partiellement transparent agencé pour afficher au moins une seconde information, ce second dispositif d'affichage (6) comprenant une cellule d'affichage électroluminescente agencée pour commuter entre un état actif dans lequel elle émet de la lumière pour afficher une information et un état passif dans lequel elle n'émet aucune lumière, et une cellule solaire (10), le second dispositif d'affichage (6) et la cellule solaire (10) étant disposés dans cet ordre sous le premier dispositif d'affichage (2), **caractérisé en ce que** la cellule d'affichage à cristal liquide réflective (20) est choisie dans le groupe formé par les cellules d'affichage à cristal liquide de type nématique en hélice, les cellules d'affichage à cristal liquide de type super nématique en hélice et les cellules d'affichage à cristal liquide de type à alignement vertical.

2. Ensemble d'affichage selon la revendication 1, **caractérisé en ce que** le premier dispositif d'affichage (2) est collé sur le second dispositif d'affichage (6) au moyen d'une couche adhésive (8).

3. Ensemble d'affichage selon la revendication 2, **caractérisé en ce que** la couche adhésive (8) est formée d'un adhésif en film ou d'une couche de colle liquide.

4. Ensemble d'affichage selon l'une quelconque des revendications 1 à 3, **caractérisé en ce que** la cellule d'affichage à cristal liquide réflective (20) est disposée entre un polariseur absorbant (30) situé du côté de l'observateur (4) et un polariseur réflectif (34) placé sous la cellule d'affichage à cristal liquide réflective (20).

5. Ensemble d'affichage selon la revendication 4, **caractérisé en ce qu'**un polariseur circulaire (38) est disposé entre la cellule d'affichage à cristal liquide réflective (20) et la cellule d'affichage électroluminescente.

6. Ensemble d'affichage selon la revendication 5, **caractérisé en ce que** le polariseur circulaire (38) comprend un second polariseur linéaire absorbant (40) et une lame quart d'onde (42).

7. Ensemble d'affichage selon la revendication 6, **caractérisé en ce que** le second polariseur linéaire absorbant (40) possède un axe de transmission qui est parallèle à un axe de transmission du polariseur réflectif (34).

8. Ensemble d'affichage selon l'une quelconque des revendications 1 à 7, **caractérisé en ce que** le second dispositif d'affichage (6) comprend une cellule d'affichage transparente TOLED (60) à diodes organiques électroluminescentes.

9. Ensemble d'affichage selon la revendication 8, **caractérisé en ce que** la cellule d'affichage transparente TOLED (60) comprend un empilement de couches électroluminescentes (64) de part et d'autre duquel sont structurées une électrode supérieure transparente (65) et une électrode inférieure transparente (66).

## Patentansprüche

1. Anordnung zum Anzeigen mindestens einer Information für einen tragbaren Gegenstand, wobei diese Anzeigeanordnung (1) eine erste Anzeigevorrichtung (2) umfasst, die zumindest teilweise lichtdurchlässig ist und sich auf Seiten eines Betrachters (4) befindet und dafür ausgelegt ist, mindestens eine erste Information anzuzeigen, wobei diese erste Anzeigevorrichtung (2) eine Flüssigkristallanzeigezelle (20) aufweist, die dafür ausgelegt ist, zwischen einem aktiven Zustand, in dem sie reflektierend ist und eine Information anzeigt, und einem passiven Zustand, in dem sie lichtdurchlässig ist und keine Information anzeigt, umzuschalten, und die Anzeigeanordnung (1) ferner eine zweite Anzeigevorrichtung (6), die zumindest teilweise lichtdurchlässig ist und dafür ausgelegt ist, mindestens eine zweite Information anzuzeigen, wobei diese zweite Anzeigevorrichtung (6) eine Elektrolumineszenzanzeigezelle aufweist, die dafür ausgelegt ist, zwischen einem aktiven Zustand, in dem sie Licht aussendet, um eine Information anzuzeigten, und einem passiven Zustand, in dem sie kein Licht aussendet, umzuschalten, und eine Solarzelle (10) umfasst, wobei die zweite Anzeigevorrichtung (6) und die Solarzelle (10) in dieser Reihenfolge unter der ersten Anzeigevorrichtung (2) angeordnet sind,
**dadurch gekennzeichnet, dass**
die reflektierende Flüssigkristallanzeigezelle (20) aus der Gruppe gewählt ist, die durch Flüssigkristallanzeigezellen vom Twisted Nematic Typ, Flüssigkristallanzeigezellen vom Super-Twisted Nematic Typ und Flüssigkristallanzeigezellen vom Vertical-Alignment Typ gebildet ist.

2. Anzeigeanordnung nach Anspruch 1, **dadurch gekennzeichnet, dass** die erste Anzeigevorrichtung (2) an die zweite Anzeigevorrichtung (6) mittels einer Klebstoffschicht (8) geklebt ist.

3. Anzeigeanordnung nach Anspruch 2, **dadurch gekennzeichnet, dass** die Klebstoffschicht (8) aus einem Klebefilm oder aus einer Schicht aus flüssigem Klebstoff gebildet ist.

4. Anzeigeanordnung nach einem der Ansprüche 1 bis 3, **dadurch gekennzeichnet, dass** die reflektierende Flüssigkristallanzeigezelle (20) angeordnet ist zwischen einem absorbierenden Polarisator (30), der sich auf Seiten des Betrachters (4) befindet, und einem reflektierenden Polarisator (34), der unter der reflektierenden Flüssigkristallanzeigezelle (20) angeordnet ist.

5. Anzeigeanordnung nach Anspruch 4, **dadurch gekennzeichnet, dass** zwischen der reflektierenden Flüssigkristallanzeigezelle (20) und der Elektrolumineszenzanzeigezelle ein Zirkularpolarisator (38) angeordnet ist.

6. Anzeigeanordnung nach Anspruch 5, **dadurch gekennzeichnet, dass** der Zirkularpolarisator (38) einen zweiten absorbierenden Linearpolarisator (40) und ein Lambda-Viertelplättchen (42) umfasst.

7. Anzeigeanordnung nach Anspruch 6, **dadurch gekennzeichnet, dass** der zweite absorbierende Linearpolarisator (40) eine Transmissionsachse besitzt, die zu einer Transmissionsachse des reflektierenden Polarisators (34) parallel ist.

8. Anzeigeanordnung nach einem der Ansprüche 1 bis 7, **dadurch gekennzeichnet, dass** die zweite Anzeigevorrichtung (6) eine lichtdurchlässige Anzeigezelle TOLED (60) mit organischen Elektrolumineszenzdioden umfasst.

9. Anzeigeanordnung nach Anspruch 8, **dadurch gekennzeichnet, dass** die lichtdurchlässige Anzeigezelle TOLED (60) einen Stapel elektrolumineszenter Schichten (64) umfasst, auf dessen einer und dessen anderer Seite eine lichtdurchlässige obere Elektrode (65) und eine lichtdurchlässige untere Elektrode (66) eingefügt sind.

## Claims

1. Assembly for displaying at least one piece of information for a portable object, said display assembly (1) including a first, at least partially transparent, display device (2) which is located on the side of an observer (4) and which is arranged to display at least a first piece of information, said first display device (2) including a liquid crystal display cell (20) arranged to switch between an active state in which the cell is reflective and displays a piece of information, and a passive state in which the cell is transparent and does not display a piece of information, said display assembly (1) also including a second, at least partially transparent, display device (6) arranged to display at least a second piece of information, said second display device (6) including a light-emitting display cell arranged to switch between an active state in which the cell emits light to display information and a passive state in which the cell does not emit any light, and a solar cell (10), the second display device (6) and the solar cell (10) being disposed in that order underneath the first display device (2), **characterized in that** the reflective liquid crystal display cell (20) is selected from the group comprising twisted nematic liquid crystal display cells, super twisted nematic liquid crystal display cells and vertically aligned liquid crystal display cells.

2. Display assembly according to claim 1, **characterized in that** the first display device (2) is bonded on the second display device (6) by means of an adhesive layer (8).

3. Display assembly according to claim 2, **characterized in that** the adhesive layer (8) is formed of an adhesive film or a liquid adhesive layer.

4. Display assembly according to any of claims 1 to 3, **characterized in that** the reflective liquid crystal display cell (20) is disposed between an absorbent polarizer (30) located on the side of the observer (4) and a reflective polarizer (34) placed underneath the reflective liquid crystal display cell (20).

5. Display assembly according to claim 4, **characterized in that** a circular polarizer (38) is disposed between the reflective liquid crystal display cell (20) and the electroluminescent display cell.

6. Display assembly according to claim 5, **characterized in that** the circular polarizer (38) includes a second absorbent linear polarizer (40) and a quarter-wave plate (42).

7. Display assembly according to claim 6, **characterized in that** the second absorbent linear polarizer (40) has an axis of transmission which is parallel to an axis of transmission of the reflective polarizer (34).

8. Display assembly according to any of claims 1 to 7, **characterized in that** the second display device (6) includes a transparent organic light-emitting (TOLED) display cell (60).

9. Display assembly according to claim 8, **characterized in that** the transparent TOLED display cell (60) includes a stack of electroluminescent layers (64) on either side of which are structured an upper transparent electrode (65) and a lower transparent electrode (66).
